# EUROPÄISCHE PATENTSCHRIFT

(11) **EP 1 187 137 B1**
(45) Veröffentlichungstag und Bekanntmachung des Hinweises auf die Patenterteilung: **28.05.2003**
(21) Anmeldenummer: 01119939.5
(22) Anmeldetag: 17.08.2001
(51) Int. Cl.: G11C 5/02, G11C 11/16

(54) **MRAM-Modulanordnung**
Modular MRAM device
Dispositif MRAM modulaire

(30) Priorität: 12.09.2000 DE 10045042
(43) Veröffentlichungstag der Anmeldung: 13.03.2002
(73) Patentinhaber: Infineon Technologies AG, 81669 München (DE)
(72) Erfinder: Boehm, Thomas, 85604 Zorneding (DE); Gogl, Dietmar, Dr., 12524 Fishkill, NY (US); Freitag, Martin, Dr., 81543 München (DE); Lammers, Stefan, Wappingerst Falls, NY 12533 (US)
(74) Vertreter: Müller - Hoffmann & Partner

(56) Entgegenhaltungen:
- EP-A- 0 543 673
- FR-A- 2 630 859
- PATENT ABSTRACTS OF JAPAN vol. 013, no. 226 (E-763), 25. Mai 1989 (1989-05-25) & JP 01 035945 A (NEC CORP), 7. Februar 1989 (1989-02-07)

## Beschreibung

Die vorliegende Erfindung betrifft eine MRAM-Modulanordnung aus einer Vielzahl von Speicherzellenfeldern, die jeweils aus einem Speicherarray mit einer Vielzahl von Speicherzellen und aus das Speicherarray an dessen Seiten umgebenden Peripherie-Schaltungen bestehen, wobei die Peripherie-Schaltungen das Speicherarray so umgeben, dass in Draufsicht jedes Speicherfeld eine im wesentlichen kreuzförmige Struktur hat.

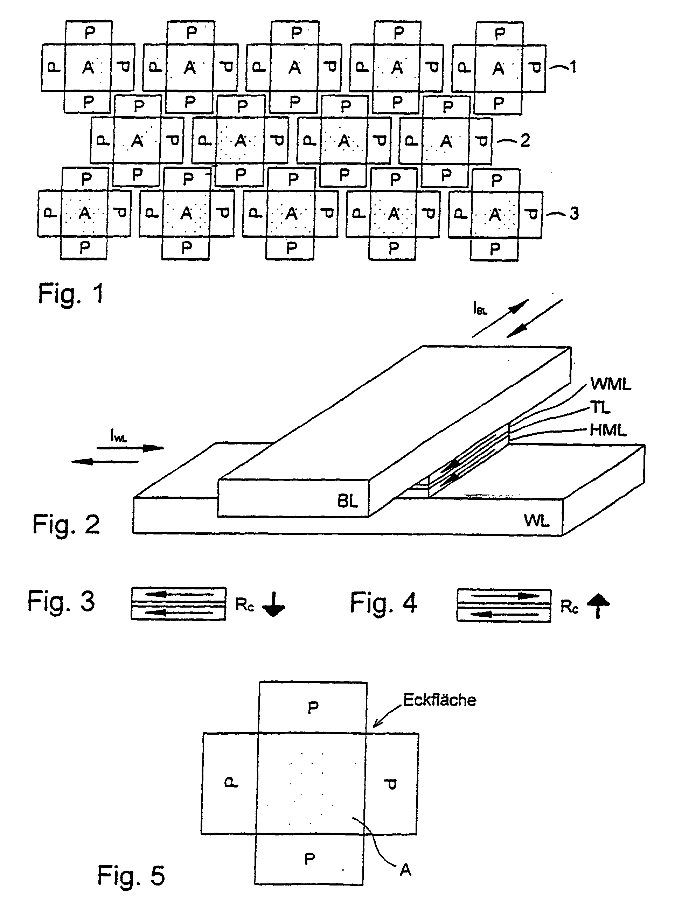

Beim MRAMs (MRAM = magnetoresistiver Speicher) liegt bekanntlich der Speichereffekt in einem magnetisch veränderbaren elektrischen Widerstand einer Speicherzelle. Fig. 2 zeigt eine solche MRAM-Speicherzelle zwischen einer Wortleitung WL und einer diese im wesentlichen senkrecht und im Abstand kreuzenden Bitleitung BL. An der Kreuzungsstelle zwischen der Wortleitung WL mit der Bitleitung BL befindet sich ein Mehrschichtsystem aus einer festen bzw. Hartmagnetschicht HML und einer freien bzw. Weichmagnetschicht WML sowie einer zwischen diesen Schichten HML und WML liegenden Tunnelbarrierenschicht TL. Die Hartmagnetschicht HML, die Tunnelbarrierenschicht TL und die Weichmagnetschicht WML bilden eine MTJ-Zelle (MTJ = Magnetic Tunnel Junction bzw. Magnet-Tunnel-Übergang).

In dieser MTJ-Zelle erfolgt eine Informationsspeicherung dadurch, dass die Magnetisierungsrichtung der Weichmagnetschicht WML gegenüber der Magnetisierungsrichtung der Hartmagnetschicht HML gedreht wird. Die hierfür erforderlichen Magnetfelder werden durch einen Strom I_{WL} in der Wortleitung WL und einen Strom I_{BL} in der Bitleitung BL erzeugt. Diese Magnetfelder überlagern sich an der Kreuzungsstelle der Wortleitung WL mit der Bitleitung BL, also im Bereich der MTJ-Zelle. Ist die Magnetisierungsrichtung beider Magnetschichten HML und WML gleich orientiert, so besitzt die MTJ-Zelle einen niedrigen elektrischen Widerstand R_{C}, wie dies in Fig. 3 veranschaulicht ist. Bei ungleicher bzw. antiparalleler Magnetisierungsrichtung in den Magnetschichten HML und WML entsteht dagegen ein hoher Widerstand, wie dies in Fig. 4 veranschaulicht ist.

Diese Widerstandsänderung zwischen paralleler Magnetisierungsrichtung und antiparalleler Magnetisierungsrichtung in den Magnetschichten HML und WML wird zur Informationsspeicherung in digitalen Speicheranwendungen genutzt.

Eine extrem hohe Speicherdichte einer MRAM-Modulanordnung kann erreicht werden, wenn mehrere Speicherzellenfelder übereinander gestapelt und jeweils mit entsprechenden zwischenliegenden Metallisierungssystemen versehen werden.

Speziell das Schalten der Ströme I_{WL} und I_{BL}, die zur Erzeugung der Magnetfelder während eines Programmiervorganges in den einzelnen MTJ-Zellen benötigt werden, erfordert aufgrund der relativ hohen Stromstärken bis zu mehreren mA flächenaufwendige Peripherie-Schaltungen aus insbesondere großen Transistoren um jedes einzelne Speicherarray. Diese Peripherie-Schaltungen müssen für eine effiziente Verdrahtung und kurze Signalwege an den Seitenrändern jedes Speicherarrays vorgesehen werden, wie dies in Fig. 5 gezeigt ist. Hier ist ein Speicherarray A an seinen Seitenrändern von vier Peripherie-Schaltungen P umgeben. Diese Peripherie-Schaltungen P sind um so größer, je mehr Speicherarrays A in verschiedenen Ebenen übereinander gestapelt werden. Bei ausreichend vielen Speicherebenen bildet sich so die in Fig. 5 gezeigte kreuzförmige Struktur aus.

Die Peripherie-Schaltungen enthalten neben Komponenten zur Stromsteuerung beim Programmiervorgang weitere Komponenten, wie beispielsweise Schalteinheiten zur Steuerung von Lesespannungen usw.

Das in Fig. 5 gezeigte Speicherzellenfeld aus dem Speicherarray A und den vier dieses Speicherarray umgebenden Peripherie-Schaltungen P ist ausreichend, um einige Megabits zu speichern. MRAM-Modulanordnungen mit noch größerer Kapazität erfordern die Kombination vieler solcher Speicherzellenfelder.

Wie aus Fig. 5 ersichtlich ist, lassen sich Speicherzellenfelder mit kreuzförmiger Struktur nicht in der von DRAMs (DRAM = dynamischer RAM) und anderen Standardspeichern gewohnten Weise einfach nebeneinander zu MRAM-Modulanordnungen in einem Speicherchip kombinieren. Durch die freien Flächen an den Ecken der kreuzförmigen Struktur entsteht eine hohe Verschwendung an Chipfläche, welche es zu verhindern gilt.

Es sei angemerkt, dass das Speicherzellenfeld nicht notwendigerweise eine quadratische Struktur besitzen muss. Auch müssen die freien Flächen an den Ecken nicht so ideal frei sein, wie dies in Fig. 5 gezeigt ist. Es soll daher unter "kreuzförmiger Struktur" eine Struktur verstanden werden, bei der jedenfalls wenigstens eine freie Fläche an einer Ecke des Speicherzellenfeldes vorliegt.

Es ist Aufgabe der vorliegenden Erfindung, eine MRAM-Modulanordnung anzugeben, bei der unter Ausnutzung von freien Eckflächen eine möglichst hohe Packungsdichte von Speicherzellenfeldern erreicht wird.

Diese Aufgabe wird bei einer MRAM-Modulanordnung der eingangs genannten Art erfindungsgemäß dadurch gelöst, dass die Speicherzellenfelder so ineinander verschachtelt sind, dass unter Ausnutzung von freien Eckflächen der kreuzförmigen Struktur eine hohe Packungsdichte der Modulanordnung vorliegt.

Die kreuzförmigen Speicherzellenfelder sind also so ausgelegt, dass sie ineinander verschachtelt werden können. Dadurch wird eine deutlich erhöhte Packungsdichte erreicht.

Dies gilt auch dann, wenn keine idealen kreuzförmigen Strukturen vorliegen, sondern jedes Speicherzellenfeld in wenigstens einem Eck eine freie Fläche hat.

Vorteilhafte Weiterbildungen der Erfindung ergeben sich aus den Unteransprüchen.

Nachfolgend wird die Erfindung anhand der Zeichnungen näher erläutert. Es zeigen:
- Fig. 1: eine schematische Draufsicht auf eine MRAM-Modulanordnung nach einem Ausführungsbeispiel der Erfindung,
- Fig. 2: eine schematische Darstellung einer MTJ-Zelle zwischen einer Wortleitung WL und einer Bitleitung BL,
- Fig. 3: eine schematische Darstellung zur Erläuterung einer parallel orientierten Magnetisierung von Magnetschichten,
- Fig. 4: eine schematische Darstellung zur Erläuterung einer antiparallel orientierten Magnetisierung von Magnetschichten und
- Fig. 5: eine schematische Draufsicht auf ein Speicherzellenfeld mit einem Speicherarray A und Peripherieschaltungen P.

Die Fig. 2 bis 5 sind bereits eingangs erläutert worden.

In den Figuren werden einander entsprechende Bauteile jeweils mit den gleichen Bezugszeichen versehen.

Wie in Fig. 1 gezeigt ist, sind bei der erfindungsgemäßen MRAM-Modulanordnung einzelne Speicherzellenfelder aus Speicherarrays A und diesen zugeordneten Peripherie-Schaltungen P so ineinander verschachtelt angeordnet, dass unter Ausnutzung von freien Eckflächen der kreuzförmigen Struktur eine hohe Packungsdichte der Modulanordnung vorliegt. Hierzu sind Reihen 1, 2, 3 der MRAM-Modulanordnung versetzt zueinander vorgesehen, so dass beispielsweise in der Reihe 2 die Peripherie-Schaltungen P, die an die Reihen 1 bzw. 3 angrenzen, genau in die Eckflächen der Speicherzellenfelder der Reihen 1 und 3 eingepasst sind.

Die einzelnen Speicherzellenfelder brauchen nicht notwendig die ideal kreuzförmige Struktur des Ausführungsbeispiels von Fig. 1 aufzuweisen. Vielmehr ist es ausreichend, wenn diese Speicherzellenfelder ungefähr eine solche kreuzförmige Struktur haben, welche ein Verschachteln der einzelnen Speicherzellenfelder verschiedenen Reihen ineinander erlaubt.

Auch brauchen die Peripherie-Schaltungen P nicht unbedingt eine ideal rechteckige Struktur zu haben. Die Speicherarrays sind vorzugsweise im wesentlichen quadratisch gestaltet. Sie können aber auch einen rechteckförmigen Rand haben oder in anderer Weise ausgeführt sein. Für die Realisierung der Erfindung ist es vollkommen ausreichend, wenn die Peripherie-Schaltungen P und die Speicherarrays A so gestaltet sind, dass sie ineinander verschachtelt werden können, um Chipfläche einzusparen.

Die Erfindung ermöglicht so die Realisierung von MRAM-Modulanordnungen von hoher Packungsdichte. Dieser wesentliche Vorteil wird allein durch die verschachtelte Gestaltung der einzelnen Reihen von Speicherzellenfeldern erreicht, welche vom bisherigen Stand der Technik beispielsweise DRAMs und Flash-Speichern grundsätzlich abweicht.

## Patentansprüche

1. MRAM-Modulanordnung aus einer Vielzahl von Speicherzellenfeldern (A, P), die jeweils aus einem Speicherarray (A) mit einer Vielzahl von Speicherzellen (WML, TL, HML) und aus das Speicherarray (A) an dessen Seiten umgebenden Peripherie-Schaltungen (P) bestehen, wobei die Peripherie-Schaltungen (P) das Speicherarray (A) so umgeben, dass in Draufsicht jedes Speicherzellenfeld (A, P) eine im wesentlichen kreuzförmige Struktur hat, **dadurch gekennzeichnet, dass** die Speicherzellenfelder (A, P) so ineinander verschachtelt sind, dass die Speicherzellenfelder (A, P) in benachbauten Reihen (1, 2) zueinander versetzt sind.

2. MRAM-Modulanordnung nach Anspruch 1,
**dadurch gekennzeichnet, dass** Peripherie-Schaltungen (P) einer Reihe (z.B. 2) der Speicherzellenfelder (A, P) in freie Eckflächen der Speicherzellenfelder (A, P) benachbarter Reihen (z.B. 1,3) hineinragen.

3. MRAM-Modulanordnung nach Anspruch 1 oder 2,
**dadurch gekennzeichnet, dass** die Peripherie-Schaltungen (P) eine im wesentlichen rechteckförmige Struktur haben.

4. MRAM-Modulanordnung nach einem der Ansprüche 1 bis 3,
**dadurch gekennzeichnet, dass** die Speicherarrays (A) im wesentlichen quadratisch oder rechteckförmig sind.

## Claims

1. MRAM module arrangement comprising a multiplicity of memory cell zones (A, P), which each comprise a memory array (A) having a multiplicity of memory cells (WML, TL, HML) and peripheral circuits (P) surrounding the memory array (A) on the sides of the latter, the peripheral circuits (P) surrounding the memory array (A) in such a way that, in plan view, each memory cell zone (A, P) has an essentially cruciform structure, **characterized in that** the memory cell zones (A, P) are nested in one another in such a way that the memory cell zones (A, P), in adjacent rows (1, 2) are offset with respect to one another.

2. MRAM module arrangement according to Claim 1,
**characterized in that**
peripheral circuits (P) of one row (e.g. 2) of the memory cell zones (A, P) project into free corner areas of the memory cell zones (A, P) of adjacent rows (e.g. 1, 3).

3. MRAM module arrangement according to Claim 1 or 2,
**characterized in that**
the peripheral circuits (P) have an essentially rectangular structure.

4. MRAM module arrangement according to one of Claims 1 to 3,
**characterized in that**
the memory arrays (A) are essentially square or rectangular.

## Revendications

1. Dispositif MRAM modulaire constitué d'une pluralité de champs (A, P) de cellules de mémoire, qui sont constitués respectivement d'un réseau (A) de mémoire ayant une pluralité de cellules (WML, TL, HML) de mémoire et de circuits (P) de périphérie entourant le réseau (A) de mémoire sur ses côtés, les circuits (P) de périphérie entourant le réseau (A) de mémoire de sorte que, én vue en plan, chaque champ (A, P) de cellules de mémoire a une structure sensiblement cruciforme, **caractérisé en ce que** les champs (A, P) de cellules de mémoire sont emboîtes les uns dans les autres, de façon à ce que les champs (A, P) de cellules de mémoire de rangées (1, 2) voisines soient décalés les uns par rapport aux autres.

2. Dispositif MRAM modulaire suivant la revendication 1,
**caractérisé**
**en ce que** les circuits (P) de périphérie d'une rangée (par exemple 2) des champs (A, P) de cellules de mémoire pénètrent dans des surfaces libres de coin des champs (A, P) de cellules de mémoire de rangées (par exemple 1, 3) voisines.

3. Dispositif MRAM modulaire suivant la revendication 1 ou 2,
**caractérisé**
**en ce que** les circuits (P) de périphérie ont une structure sensiblement rectangulaire.

4. Dispositif MRAM modulaire suivant l'une des revendications 1 à 3,
**caractérisé**
**en ce que** les réseaux (A) de mémoire sont sensiblement carrés ou rectangulaires.
